# EUROPEAN PATENT APPLICATION

(11) **EP 4 738 398 A2**
(43) Date of publication of application: **06.05.2026**
(21) Application number: 25212359.1
(22) Date of filing: 30.10.2025
(51) Int. Cl.: H01F 17/00, H10W 20/40

(54) **LAMINATE NON-PLANAR RADIO-FREQUENCY CHOKE DEVICE**

(30) Priority: 30.10.2024 US 202463713586 P; 29.10.2025 US 202519372284
(71) Applicant: MEDIATEK INC., Hsinchu City 30078 (TW)
(72) Inventor: IBRAHIM, Mahmoud Ayman Ahmed, San Jose, CA, 95134 (US); SHABRA, Ayman, San Jose, CA, 95134 (US)
(74) Representative: Pfenning, Meinig & Partner mbB

(57) **Abstract**

A laminate non-planar radio-frequency, RF, choke device includes a first RF choke (200). The first RF choke (200) has a first winding structure including a plurality of first conductive traces (202, 204) and a plurality of first vias (206, 208). The first conductive traces (202, 204) are formed on a first layer (L1) and a second layer (L3) of a laminate. The first vias (206, 208) are formed between the first layer (L1) and the second layer (L3) of the laminate. The first vias (206, 208) are stitched in a winding direction through the first conductive traces (202, 204).

## Description

### Field of the Invention

The present invention relates to a radio-frequency (RF) choke design, and more particularly, to a laminate non-planar RF choke device having at least one RF choke created by stitching vias formed between different layers of a laminate.

### Background of the Invention

An RF choke is a type of inductor used in electronic circuits to block or filter RF signal (i.e., high-frequency signals) while allowing low-frequency or direct current (DC) signals to pass through. One conventional RF choke may be implemented using an on-die inductor. However, an on-die RF choke consumes a large die area in new semiconductor technologies, and has very limited performance due to its low quality factor. Another conventional RF choke may be implemented using a laminate planar inductor (i.e., a spiral inductor formed on a laminate). However, the laminate planar RF choke consumes a large area and has a low self-resonance frequency. In addition, the laminate planar RF choke causes interference because of the nature of its geometry. As a result, a direction of a magnetic field induced by a current flowing through the laminate planar RF choke is perpendicular to a surface of the laminate. Since the magnetic field is not contained, other circuit components are interfered with the magnetic field induced by the laminate planar RF choke. Furthermore, it is hard to pitch-match since the laminate planar RF choke occupies large x and y directions, leading to long routing traces with uncontrolled impedance and reflections.

### Summary of the Invention

This in mind, the present invention aims at providing a laminate non-planar RF choke device having at least one RF choke created by stitching vias formed between different layers of a laminate.

This is achieved by a laminate non-planar RF choke device according to the independent claim. The dependent claims pertain to corresponding further developments and improvements.

As will be seen more clearly from the detailed description following below, the claimed laminate non-planar RF choke device includes a first RF choke. The first RF choke has a first winding structure including a plurality of first conductive traces and a plurality of first vias. The first conductive traces are formed on a first layer and a second layer of a laminate. The first vias are formed between the first layer and the second layer of the laminate. The first vias are stitched in a winding direction through the first conductive traces.

### Brief Description of the Drawings

In the following, the invention is further illustrated by way of example, taking reference to the accompanying drawings. Thereof
FIG. 1 is a diagram illustrating a laminate non-planar RF choke device according to an embodiment of the present invention,
FIG. 2 is a diagram illustrating a laminate non-planar RF choke with the proposed RF choke topology according to an embodiment of the present invention,
FIG. 3 is a diagram illustrating a single-ended implementation with the use of two adjacent laminate non-planar RF chokes according to an embodiment of the present invention,
FIG. 4 is a diagram illustrating a differential implementation with the use of two adjacent laminate non-planar RF chokes according to an embodiment of the present invention, and
FIG. 5 is a diagram illustrating laminate non-planar RF chokes that are pitch-matched to circuit blocks in a die according to an embodiment of the present inventions.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

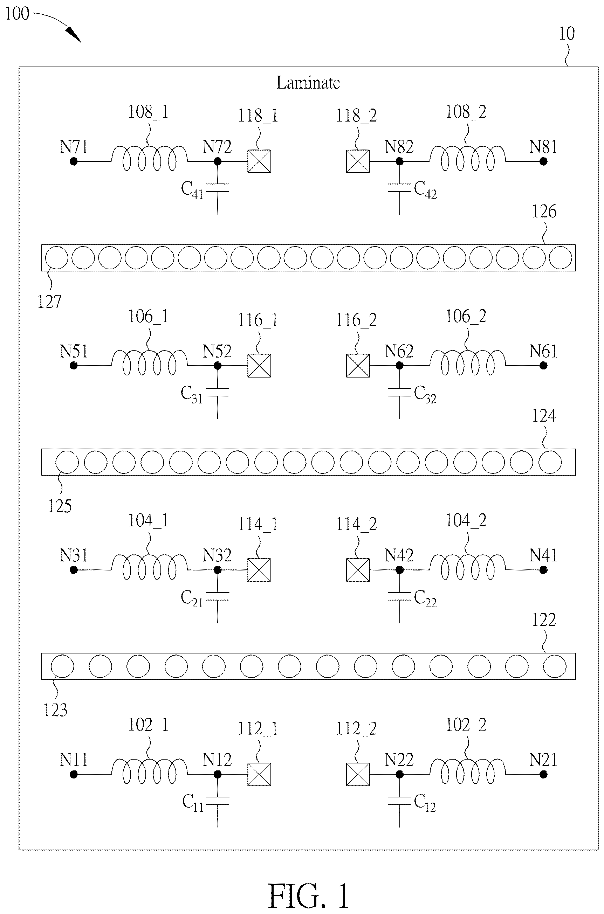

FIG. 1 is a diagram illustrating a laminate non-planar RF choke device according to an embodiment of the present invention. The laminate non-planar RF choke device 100 may include one or more laminate non-planar RF chokes formed in a laminate 10, where the laminate 10 has multiple layers, including metal layers and insulation layers. For better comprehension of technical features of the present invention, only eight laminate non-planar RF chokes 102_1, 102_2, 104_1, 104_2, 106_1, 106_2, 108_1, 108_2 are illustrated in FIG. 1. In practice, the present invention has no limitations on the number of non-planar RF chokes implemented in the same laminate.

Consider a case where the laminate non-planar RF choke device 100 is used by a wireless communication application, a first RF choke bank, including laminate non-planar RF chokes 102_1 and 102_2, may be used by a first receiver (RX) front-end at a first channel; a second RF choke bank, including laminate non-planar RF chokes 104_1 and 104_2, may be used by a second RX front-end at a second channel; a third RF choke bank, including laminate non-planar RF chokes 106_1 and 106_2, may be used by a third RX front-end at a third channel; and a fourth RF choke bank, including laminate non-planar RF chokes 108_1 and 108_2, may be used by a fourth RX front-end at a fourth channel. However, this is for illustrative purposes only, and is not meant to be a limitation of the present invention. In practice, any application using the proposed laminate non-planar RF choke falls within the scope of the present invention.

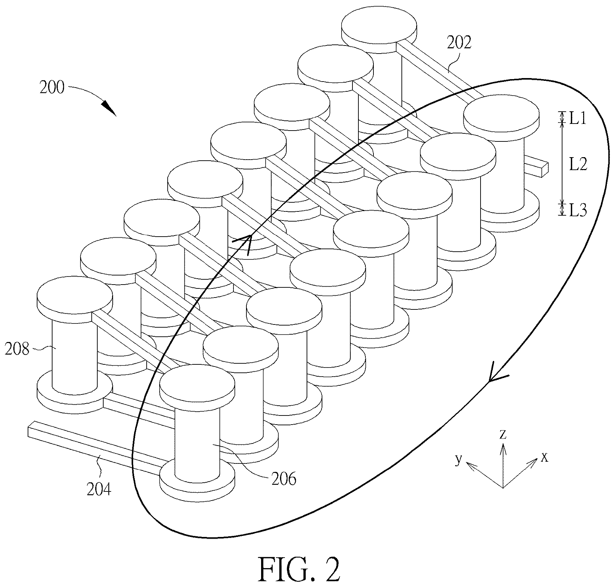

Each of the laminate non-planar RF chokes 102_1, 102_2, 104_1, 104_2, 106_1, 106_2, 108_1, 108_2 is implemented using the proposed RF choke topology. FIG. 2 is a diagram illustrating a laminate non-planar RF choke with the proposed RF choke topology according to an embodiment of the present invention. Each of the laminate non-planar RF chokes 102_1, 102_2, 104_1, 104_2, 106_1, 106_2, 108_1, 108_2 shown in FIG. 1 may be implemented using the laminate non-planar RF choke 200 shown in FIG. 2. The laminate non-planar RF choke 200 has a winding structure, including a plurality of conductive traces 202, 204 and a plurality of vias 206, 208. Conductive traces 202 are formed on one layer (e.g., metal layer) L1 of the laminate 10. Conductive traces 204 are formed on another layer (e.g., metal layer) L3 of the laminate 10. There may be at least one layer (e.g., insulation layer) L2 sandwiched between layers L1 and L2. It should be noted that the laminate 10 may include additional layer(s) above the layer L1, and/or the laminate 10 may include additional layer(s) under the layer L2.

The vias 206 and 208 are formed between layers L1 and L2 of the laminate. In accordance with the proposed RF choke topology, the vias 206 and 208 are stitched in a winding direction (e.g., clockwise direction or counterclockwise direction) through the conductive traces 202 and 204. As shown in FIG. 2, a solenoid inductor consisting of conductive traces and vias is created in the x direction of layers L1-L3. Specifically, the winding structure of the laminate non-planar RF choke 200 includes a plurality of loops, each having one via 206 and one via 208. Due to the non-planar arrangement adopted by the proposed RF choke topology, a direction of a magnetic field induced by a current flowing through the winding structure of the laminate non-planar RF choke 200 is parallel to a surface of the laminate 10. When a die is mounted on the laminate 10, the direction of the magnetic field induced by the current flowing through the winding structure of the laminate non-planar RF choke 200 is also parallel to a surface of the die.

In some embodiments of the present invention, the laminate non-planar RF choke 200 can be shielded by additional layers of the laminate 10 (e.g., a top layer above the RF choke and/or a bottom layer under the RF choke) to mitigate/cancel interference picked by circuit components in the vicinity of the laminate non-planar RF choke 200.

Furthermore, the effective length of the laminate non-planar RF choke 200 (which is a solenoid inductor consisting of conductive traces 202, 204 and vias 206, 208) can be large since it stitches around laminate layers, which leads to a higher value for the RF choke and also leads to covering a wider range of frequencies, starting from very low frequencies up to very high frequencies in broadband applications.

In some embodiments of the present invention, winding directions (i.e., stitching directions) of two adjacent laminate non-planar RF chokes may be properly configured to support a single-ended implementation (i.e., a common-mode RF choke) or a differential implementation (i.e., a differential RF choke).

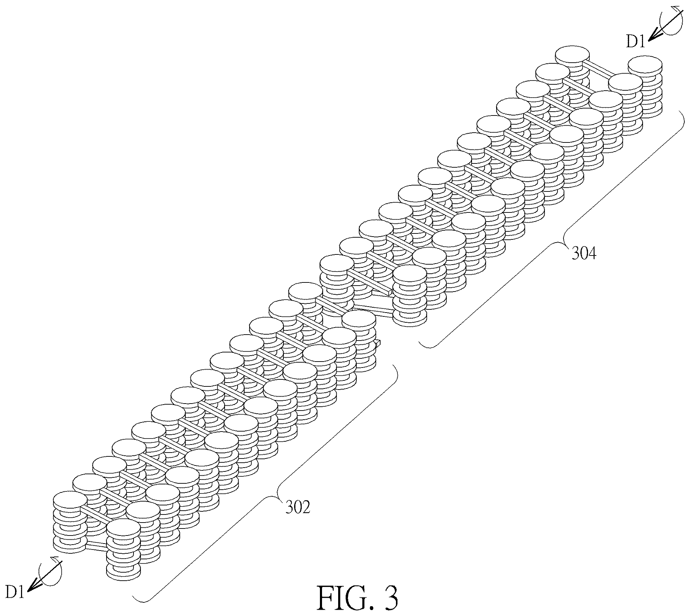

FIG. 3 is a diagram illustrating a single-ended implementation with the use of two adjacent laminate non-planar RF chokes according to an embodiment of the present invention. The laminate non-planar RF chokes 302 and 304 may be laminate non-planar RF chokes of the same RF choke bank. For example, the laminate non-planar RF chokes 302 and 304 may be laminate non-planar RF chokes 102_1 and 102_2 shown in FIG. 1, or laminate non-planar RF chokes 104_1 and 104_2 shown in FIG. 1, or laminate non-planar RF chokes 106_1 and 106_2 shown in FIG. 1, or laminate non-planar RF chokes 108_1 and 108_2 shown in FIG. 1. Hence, each of the laminate non-planar RF chokes 302 and 304 has the proposed RF choke topology shown in FIG. 2. Since a person skilled in the art can readily understand structure details of the laminate non-planar RF chokes 302 and 304 after reading above paragraphs directed to the proposed RF choke topology shown in FIG. 2, further description is omitted here for brevity.

As shown in FIG. 3, one end of the winding structure of the laminate non-planar RF choke 302 is adjacent to one end of the winding structure of the laminate non-planar RF choke 304. The winding directions (i.e., stitching directions) of adjacent laminate non-planar RF chokes 302 and 304 are properly configured, such that a direction D1 of a magnetic field induced by a current flowing through the winding structure of the laminate non-planar RF choke 304 is identical to a direction D1 of a magnetic field induced by a current flowing through the winding structure of the laminate non-planar RF choke 302. Due to addition of magnetic fields, the laminate non-planar RF chokes 302 and 304 operate like a common-mode RF choke. Regarding a wireless communication application, the single-ended implementation can be used for single-ended signal processing of every channel.

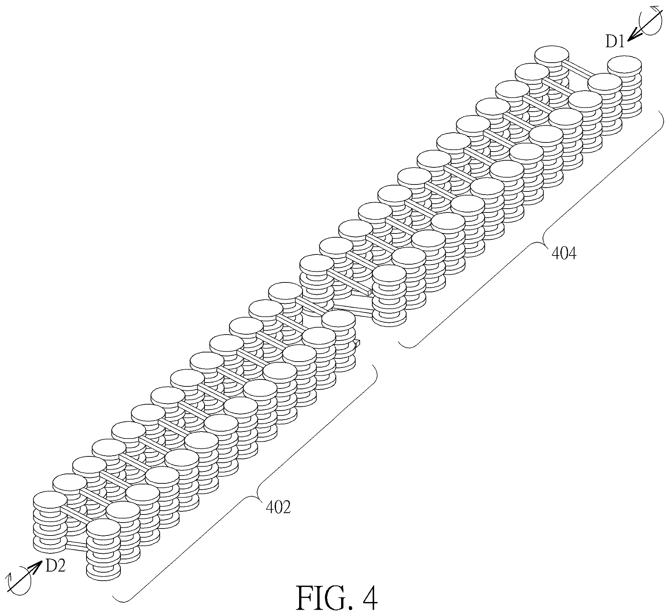

FIG. 4 is a diagram illustrating a differential implementation with the use of two adjacent laminate non-planar RF chokes according to an embodiment of the present invention. The laminate non-planar RF chokes 402 and 404 may be laminate non-planar RF chokes of the same RF choke bank. For example, the laminate non-planar RF chokes 402 and 404 may be laminate non-planar RF chokes 102_1 and 102_2 shown in FIG. 1, or laminate non-planar RF chokes 104_1 and 104_2 shown in FIG. 1, or laminate non-planar RF chokes 106_1 and 106_2 shown in FIG. 1, or laminate non-planar RF chokes 108_1 and 108_2 shown in FIG. 1. Hence, each of the laminate non-planar RF chokes 402 and 404 has the proposed RF choke topology shown in FIG. 2. Since a person skilled in the art can readily understand structure details of the laminate non-planar RF chokes 402 and 404 after reading above paragraphs directed to the proposed RF choke topology shown in FIG. 2, further description is omitted here for brevity.

As shown in FIG. 4, one end of the winding structure of the laminate non-planar RF choke 402 is adjacent to one end of the winding structure of the laminate non-planar RF choke 404. The winding directions (i.e., stitching directions) of adjacent laminate non-planar RF chokes 402 and 404 are properly configured, such that a direction D1 of a magnetic field induced by a current flowing through the winding structure of the laminate non-planar RF choke 404 is opposite to a direction D2 of a magnetic field induced by a current flowing through the winding structure of the laminate non-planar RF choke 402. Due to subtraction of magnetic fields, the laminate non-planar RF chokes 402 and 404 operate like a differential RF choke. Regarding a wireless communication application, the differential implementation can be used for differential signal processing of every channel.

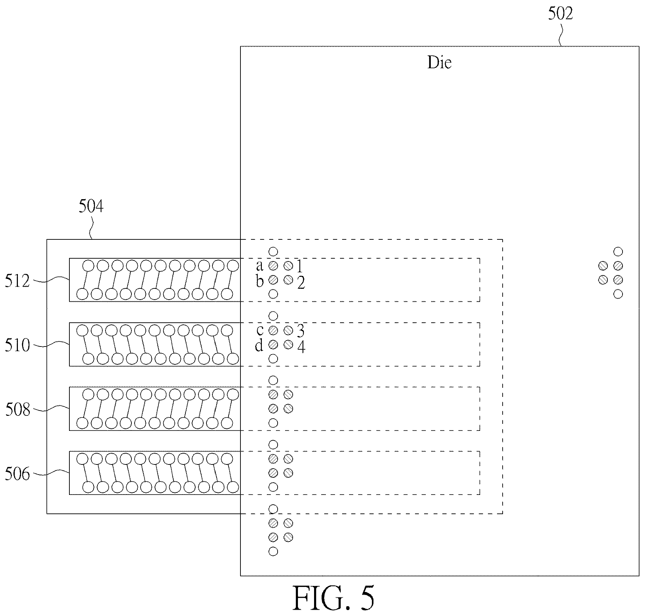

As shown in FIG. 2, the solenoid inductor consisting of conductive traces 202, 204 and vias 206, 208 is created in only a single direction (i.e., x direction). The value of the laminate non-planar RF choke can be easily enlarged by expanding the solenoid inductor in the x direction, without changing a width of the laminate non-planar RF choke in the y direction. Hence, during a design phase, the laminate non-planar RF choke can still be pitch-matched to a circuit block (e.g., RX front-end) on a die while enlarging it in the x direction. As illustrated in FIG. 5, laminate non-planar RF choke device 504 has RF choke banks 506, 508, 510, 512, each including one or more laminate non-planar RF chokes that are pitch-matched to critical circuit blocks in a die 502.

In addition to RF chokes, additional components may be formed in the same laminate. As shown in FIG. 1, the laminate non-planar RF choke device 100 may further include a plurality of isolation trenches 122, 124, 126 and a plurality of decoupling capacitors C₁₁, C₁₂, C₂₁, C₂₂, C₃₁, C₃₂, C₄₁, C₄₂, all of which are formed in the same laminate 10 by which the laminate non-planar RF chokes 102_1, 102_2, 104_1, 104_2, 106_1, 106_2, 108_1, 108_2 are created. Specifically, the laminate non-planar RF choke 102_1 has two ends N11 and N12, where a decoupling capacitor C₁₁ and a pad 112_1 are connected to the end N12; the laminate non-planar RF choke 102_2 has two ends N21 and N22, where a decoupling capacitor C₁₂ and a pad 112_2 are connected to the end N22; the laminate non-planar RF choke 104_1 has two ends N31 and N32, where a decoupling capacitor C₂₁ and a pad 114_1 are connected to the end N32; the laminate non-planar RF choke 104_2 has two ends N41 and N42, where a decoupling capacitor C₂₂ and a pad 114_2 are connected to the end N42; the laminate non-planar RF choke 106_1 has two ends N51 and N52, where a decoupling capacitor C₃₁ and a pad 116_1 are connected to the end N52; the laminate non-planar RF choke 106_2 has two ends N61 and N62, where a decoupling capacitor C₃₂ and a pad 116_2 are connected to the end N62; the laminate non-planar RF choke 108_1 has two ends N71 and N72, where a decoupling capacitor C₄₁ and a pad 118_1 are connected to the end N72; and the laminate non-planar RF choke 108_1 has two ends N81 and N82, where a decoupling capacitor C₄₂ and a pad 118_2 are connected to the end N82.

In some embodiments of the present invention, the laminate non-planar RF chokes 102_1, 102_2, 104_1, 104_2, 106_1, 106_2, 108_1, 108_2 may be supply referenced. For example, ends N11, N21, N31, N41, N51, N61, N71, N81 may be coupled to a supply voltage, and ends N12, N22, N32, N42, N52, N62, N72, N82 may be coupled to a ground voltage through decoupling capacitors C₁₁, C₁₂, C₂₁, C₂₂, C₃₁, C₃₂, C₄₁, C₄₂, respectively.

In some embodiments of the present invention, the laminate non-planar RF chokes 102_1, 102_2, 104_1, 104_2, 106_1, 106_2, 108_1, 108_2 may be ground referenced. For example, ends N11, N21, N31, N41, N51, N61, N71, N81 may be coupled to a ground voltage, and ends N12, N22, N32, N42, N52, N62, N72, N82 may be coupled to a supply voltage through decoupling capacitors C₁₁, C₁₂, C₂₁, C₂₂, C₃₁, C₃₂, C₄₁, C₄₂, respectively.

The RF choke is used to block high-frequency signals, and acts like high impedance at an RF band. The decoupling capacitor is used to bypass high-frequency noise to a reference voltage, and acts like low impedance at an RF band. Hence, the RF choke and the decoupling capacitor can be jointly used to block the supply/ground voltage from being interfered with the high-frequency noise. In this embodiment, each of the decoupling capacitors C₁₁, C₁₂, C₂₁, C₂₂, C₃₁, C₃₂, C₄₁, C₄₂ is a built-in capacitor for a corresponding laminate non-planar RF choke. With the aid of multiple layers of the laminate 10, each of the decoupling capacitors C₁₁, C₁₂, C₂₁, C₂₂, C₃₁, C₃₂, C₄₁, C₄₂ can be implemented using a metal-insulator-metal structure. Since the decoupling capacitors C₁₁, C₁₂, C₂₁, C₂₂, C₃₁, C₃₂, C₄₁, C₄₂ are implemented using the laminate 10, there is no need to use surface mount device (SMD) decoupling capacitors, thus avoiding long routing traces that create impedance flipping.

The laminate non-planar RF choke device 100 may be placed directly under a die, such that the pads 112_1, 112_2, 114_1, 114_2, 116_1, 116_2, 118_1, 118_2 can be connected to pads of the die that are connected to critical circuit blocks (e.g., RX front-ends) on the die, leading to elimination of routing traces between die pads and laminate RF chokes.

As shown in FIG. 1, the isolation trench 122 is between laminate non-planar RF chokes 102_1, 102_2 of one RF choke bank and laminate non-planar RF chokes 104_1, 104_2 of an adjacent RF choke bank; the isolation trench 124 is between laminate non-planar RF chokes 104_1, 104_2 of one RF choke bank and laminate non-planar RF chokes 106_1, 106_2 of an adjacent RF choke bank; and the isolation trench 126 is between laminate non-planar RF chokes 106_1, 106_2 of one RF choke bank and laminate non-planar RF chokes 108_1, 108_2 of an adjacent RF choke bank. Each of the isolation trenches 122, 124, 126 is used to provide insulation between adjacent RF choke banks. In this embodiment, the isolation trench 122 is implemented by a via trench including vias 123 that are formed in the laminate 10 and connected to the ground voltage, the isolation trench 124 is implemented by a via trench including vias 125 that are formed in the laminate 10 and connected to the ground voltage, and the isolation trench 126 is implemented by a via trench including vias 127 that are formed in the laminate 10 and connected to the ground voltage.

Regarding the proposed RF choke topology shown in FIG. 2, the vias 206 and 208 are arranged in a linear fashion, leading to a laminate non-planar RF choke 200 with a linear form. However, this is for illustrative purposes only, and is not meant to be a limitation of the present invention. Alternatively, the laminate non-planar RF choke may be in a U-shaped form, a toroid-shaped form, or any other form, depending upon actual design considerations.

In some embodiments of the present invention, the laminate 10 may be a substrate of a semiconductor package. In some embodiments of the present invention, the laminate 10 may be an interposer of a semiconductor package. In some embodiments of the present invention, the laminate 10 may be a substrate of an integrated passive device (PID).

Since RF chokes are implemented in the laminate and are not included in a die, the die area can be saved significantly. In addition, since RF chokes are omitted from a die, tighter integration of critical blocks in the die can be achieved, and the signal paths can shrink, leading to lower signal losses, less reflections, less IR drop, better stability, and improved performance.

## Claims

1. A laminate non-planar radio-frequency, RF, choke device (100) **characterized by**:
a first RF choke (102_1, 102_2, 104_1, 104_2, 106_1, 106_2, 108_1, 108_2, 200), comprising:
a first winding structure, comprising:
a plurality of first conductive traces (202, 204), formed on a first layer (L1) and a second layer (L3) of a laminate (10); and
a plurality of first vias (206, 208), formed between the first layer (L1) and the second layer (L3) of the laminate (10), wherein the plurality of first vias (206, 208) are stitched in a winding direction through the plurality of first conductive traces (202, 204).

2. The laminate non-planar RF choke device (100) of claim 1, **characterized in that** a direction of a magnetic field induced by a current flowing through the first winding structure is parallel to a surface of the laminate (10).

3. The laminate non-planar RF choke device (100) of any one of claims 1 or 2, **characterized in that** the first winding structure comprises a plurality of loops, each comprising two of the plurality of first vias (206, 208).

4. The laminate non-planar RF choke device (100) of any one of claims 1 to 3, **characterized in that** the laminate non-planar RF choke device (100) further comprises:
a decoupling capacitor (C₁₁, C₁₂, C₂₁, C₂₂, C₃₁, C₃₂, C₄₁, C₄₂), coupled to a first end of the first winding structure, wherein the decoupling capacitor (C₁₁, C₁₂, C₂₁, C₂₂, C₃₁, C₃₂, C₄₁, C₄₂) is formed in the laminate (10), and has a metal-insulator-metal structure.

5. The laminate non-planar RF choke device (100) of claim 4, **characterized in that** the first end of the first winding structure is coupled to a supply voltage through the decoupling capacitor (C₁₁, C₁₂, C₂₁, C₂₂, C₃₁, C₃₂, C₄₁, C₄₂).

6. The laminate non-planar RF choke device (100) of any one of claims 4 or 5, **characterized in that** the first end of the first winding structure is coupled to a ground voltage through the decoupling capacitor (C₁₁, C₁₂, C₂₁, C₂₂, C₃₁, C₃₂, C₄₁, C₄₂).

7. The laminate non-planar RF choke device (100) of any one of claims 1 to 6, **characterized in that** the laminate (10) is a substrate of a semiconductor package.

8. The laminate non-planar RF choke device (100) of any one of claims 1 to 7, **characterized in that** the laminate (10) is an interposer of a semiconductor package.

9. The laminate non-planar RF choke device (100) of any one of claims 1 to 8, **characterized in that** the laminate (10) is a substrate of an integrated passive device.

10. The laminate non-planar RF choke device (100) of any one of claims 1 to 9, **characterized in that** the laminate non-planar RF choke device (100) further comprises:
a second RF choke (102_1, 102_2, 104_1, 104_2, 106_1, 106_2, 108_1, 108_2, 200), comprising:
a second winding structure, comprising:
a plurality of second conductive traces (202, 204), formed on the first layer (L1) and the second layer (L3) of the laminate (10); and
a plurality of second vias (206, 208), formed between the first layer (L1) and the second layer (L3) of the laminate (10), wherein the plurality of second vias (206, 208) are stitched in a winding direction through the plurality of second conductive traces (202, 204).

11. The laminate non-planar RF choke device (100) of claim 10, **characterized in that** one end of the second winding structure is adjacent to one end of the first winding structure, and a direction of a magnetic field induced by a current flowing through the second winding structure is identical to a direction of a magnetic field induced by a current flowing through the first winding structure.

12. The laminate non-planar RF choke device (100) of any one of claims 10 or 11, **characterized in that** one end of the second winding structure is adjacent to one end of the first winding structure, and a direction of a magnetic field induced by a current flowing through the second winding structure is opposite to a direction of a magnetic field induced by a current flowing through the first winding structure.

13. The laminate non-planar RF choke device (100) of any one of claims 10 to 12, **characterized in that** the laminate non-planar RF choke device (100) further comprises:
an isolation trench (122, 124, 126), between the first RF choke (102_1, 102_2, 104_1, 104_2, 106_1, 106_2, 108_1, 108_2) and the second RF choke (102_1, 102_2, 104_1, 104_2, 106_1, 106_2, 108_1, 108_2), wherein the isolation trench (122, 124, 126) comprises vias that are formed in the laminate (10) and connected to a ground voltage.
